# EUROPEAN PATENT SPECIFICATION

(11) **EP 4 271 864 B1**
(45) Date of publication and mention of the grant of the patent: **11.12.2024**
(21) Application number: 21848493.9
(22) Date of filing: 31.12.2021
(51) Int. Cl.: C30B 15/04, C30B 29/06

(54) **SYSTEMS AND METHODS FOR PRODUCING A SINGLE CRYSTAL SILICON INGOT USING A VAPORIZED DOPANT**
SYSTEME UND VERFAHREN ZUR HERSTELLUNG EINES EINKRISTALL-SILICIUMBLOCKS MIT EINEM VERDAMPFTEN DOTIERUNGSSTOFF
SYSTÈMES ET PROCÉDÉS DE PRODUCTION D'UN LINGOT DE SILICIUM MONOCRISTALLIN UTILISANT UN AGENT DOPANT VAPORISÉ

(30) Priority: 31.12.2020 US 202017139352; 31.12.2020 US 202017139367
(43) Date of publication of application: 08.11.2023
(73) Proprietor: GlobalWafers Co., Ltd., Hsinchu (TW)
(72) Inventor: WU, Yu-Chiao, St. Peters, Missouri 63376 (US); LUTER, William Lynn, St. Peters, Missouri 63376 (US); PHILLIPS, Richard J., St. Peters, Missouri 63376 (US); EOFF, James Dean, St. Peters, Missouri 63376 (US)
(74) Representative: Maiwald GmbH
(86) International application number: PCT/US2021/065810
(87) International publication number: WO 2022/147344

(56) References cited:
- WO-A1-2020/263455
- JP-A- 2011 132 043
- US-A1- 2010 294 999

## Description

### FIELD

The present invention relates to systems and methods for producing a single crystal silicon ingot using a vaporized dopant.

### BACKGROUND

In high resistivity silicon wafer applications, the resistivity of the single crystal silicon ingot from which the wafers are sliced may be controlled by addition of various dopants to the melt. The dopants may be used to compensate for various impurities (e.g., boron or phosphorous) in the source of polycrystalline silicon used to form a melt from which the silicon ingot is withdrawn.

When one or more dopants are added to achieve a target resistivity in the ingot, certain dopants and/or impurities may accumulate in the melt due to differences in the segregation coefficients of the compounds. For example, boron has a segregation coefficient of about 0.8 which allows boron to be readily taken up into the growing ingot. Phosphorous has a segregation coefficient of about 0.35 which causes phosphorous to accumulate in the melt relative to boron which is taken up more readily. Accordingly, as the ingot grows and the melt is depleted, phosphorous accumulates in the melt altering the resistivity of the growing ingot. This can cause the resistivity to decrease and fall out of customer specifications and/or for a type-change to occur in the ingot.

A need exists for methods for counter-doping a silicon melt during ingot growth to increase the length of the ingot that remains within customer specifications. A need also exists for doping methods that allow for use of dopant source materials that are readily available and/or relatively inexpensive and that allow the melt to be doped with relative ease. Further, an ingot puller apparatus that allows a liquid-phase dopant to be used as the source of dopant is needed.

WO 2020/263455 A1 describes methods for producing a silicon crystal silicon ingot. The ingot is doped with boron using solid-phase boric acid as the source of boron. Ingot puller apparatus that use a solid-phase dopant are also disclosed. The solid-phase dopant may be disposed in a receptacle that is moved closer to the surface of the melt or a vaporization unit may be used to produce a dopant gas from the solid-phase dopant.

JP 2011 132043 A1 describes a silicon single crystal pulling device and a method for producing a silicon single crystal using the pulling device, using sublimation of the dopant during addition or flipping on a liquid surface of a silicon melt.

### SUMMARY

In one aspect of the present invention, an ingot puller apparatus for producing a doped single crystal silicon ingot includes a housing defining a chamber, a crucible disposed within the chamber, and a dopant injector extending into the housing. The dopant injector includes a delivery module attached to and extending through the housing into the chamber. The delivery module includes a dopant injection tube positioned within the chamber and a vaporization cup positioned within the dopant injection tube and the chamber. A valve selectively channels the liquid dopant into the vaporization cup and the vaporization cup vaporizes the liquid dopant into a vaporized dopant.

In another aspect of the present invention, an ingot puller apparatus for producing a doped single crystal silicon ingot includes a housing defining a chamber, a crucible disposed within the chamber, and a dopant injector extending into the housing. The dopant injector includes an injection module attached to an outer surface of the housing. The injection module includes a first reservoir for containing a liquid dopant, a second reservoir for containing the liquid dopant, a first valve for selectively channeling the liquid dopant from the first reservoir to the second reservoir, and a second valve for selectively channeling the liquid dopant from the second reservoir to the chamber. The dopant injector also includes a delivery module attached to the injection module and extending through the housing into the chamber. The second valve selectively channels the liquid dopant into the delivery module and the delivery module vaporizes the liquid dopant into a vaporized dopant.

In another aspect of the present invention, a method for producing a single crystal silicon ingot from a silicon melt held within a crucible positioned within an ingot puller apparatus is provided. The ingot puller apparatus includes a dopant injector extending into a housing of the ingot puller apparatus, the dopant injector including a first reservoir, a first valve, a second reservoir, a second valve, a dopant injection tube positioned within the housing, and a vaporization cup positioned within the dopant injection tube and the housing. The method includes adding polycrystalline silicon to the crucible. The crucible is disposed within an ingot puller inner chamber. The method also includes heating the polycrystalline silicon to cause a silicon melt to form in the crucible. The method further includes pulling a single crystal silicon ingot from the silicon melt. The method also includes injecting a liquid dopant into the ingot puller apparatus by channeling the liquid dopant from the first reservoir to the second reservoir by opening the first valve and channeling the liquid dopant from the second reservoir to the housing by opening the second valve. The method further includes vaporizing the liquid dopant into a vaporized dopant within the ingot puller apparatus by heating the liquid dopant using the vaporization cup and reducing a pressure of the liquid dopant by injecting the liquid dopant into the housing, wherein the housing is maintained at a pressure below atmospheric pressure. The method also includes contacting the vaporized dopant with a surface of the melt to cause the vaporized dopant to enter the melt as a dopant while pulling the single crystal silicon ingot from the melt.

In another aspect, a method for doping a single crystal silicon ingot pulled from a silicon melt held within a crucible positioned within an ingot puller apparatus. The ingot puller apparatus includes a housing, a dopant injector extending into the housing, and a heating system positioned with the housing. The dopant injector including a dopant injection tube positioned within the housing and a vaporization cup positioned within the dopant injection tube and the housing. The method includes heating the vaporization cup using the heating system. The method also includes injecting liquid dopant into the dopant injection tube and the vaporization cup. The method further includes vaporizing the liquid dopant into vaporized dopant within the housing. The liquid dopant is vaporized by flash evaporation by heating the liquid dopant with the vaporization cup. The method also includes channeling the vaporized dopant into the housing using the dopant injection tube.

Various refinements exist of the features noted in relation to the above-mentioned aspects of the present invention. Further features may also be incorporated in the above-mentioned aspects of the present invention as well.

### BRIEF DESCRIPTION OF THE DRAWINGS

FIG. 1 is a partial cross-section side view of an embodiment of an ingot puller apparatus having a dopant injector.
FIG. 2 is a perspective view of the dopant injector shown in FIG. 1.
FIG. 3 is a cross-section perspective view of the dopant injector shown in FIG. 1.
FIG. 4A is a cross-section perspective view of the dopant injector shown in FIG. 1.
FIG. 4B is a detailed cross-section perspective view of the dopant chamber shown in FIG. 4A.
FIG. 5A is a cross-section perspective view of the dopant injector shown in FIG. 1.
FIG. 5B is a detailed cross-section perspective view of the dopant chamber shown in FIG. 5A.
FIG. 6A is a cross-section perspective view of the dopant injector shown in FIG. 1.
FIG. 6B is a detailed cross-section perspective view of the delivery module shown in FIG. 6A.
FIG. 7 is a cross-section perspective view of the vaporization cup shown in FIG. 3.
FIG. 8 is a graph of ingot resistivity as a function of ingot length.
FIG. 9 is a schematic of an example method of producing a single crystal silicon ingot.
FIG. 10 is a schematic of an example method of doping a single crystal silicon ingot.
Corresponding reference characters indicate corresponding parts throughout the drawings.

### DETAILED DESCRIPTION

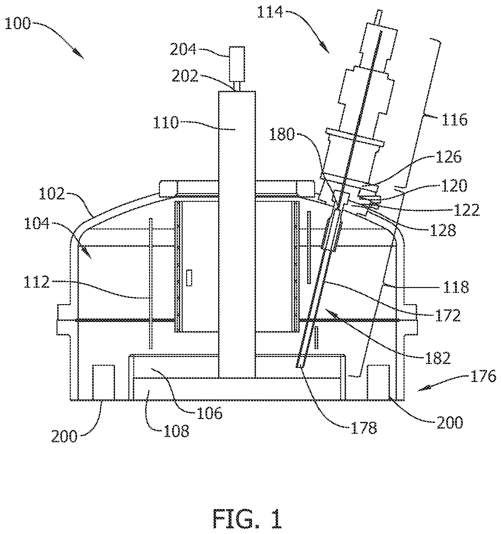

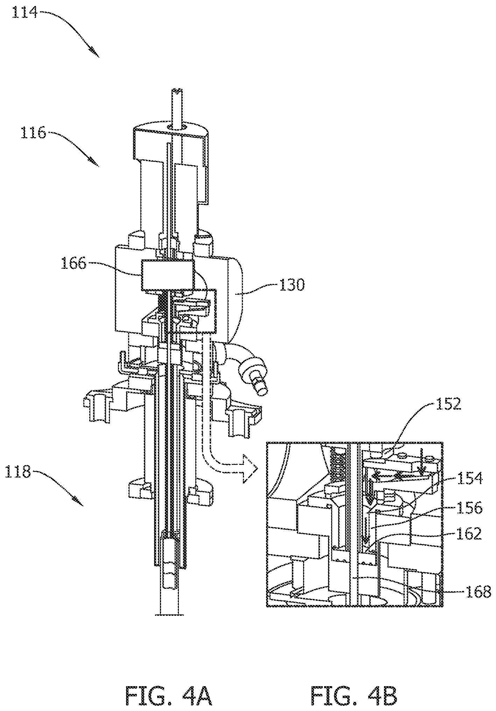

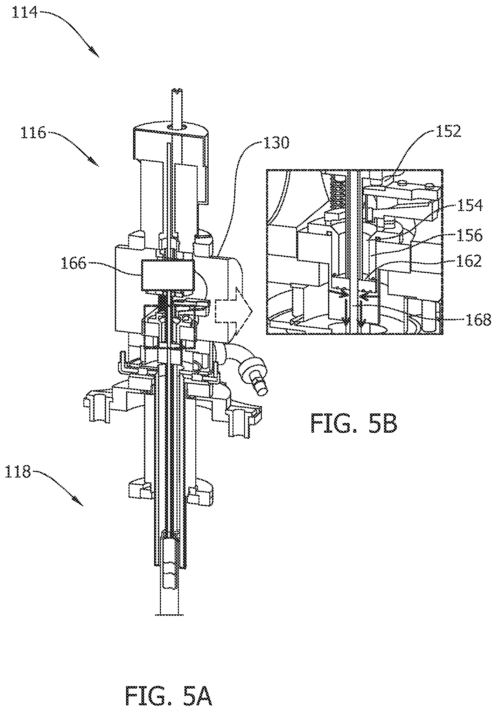

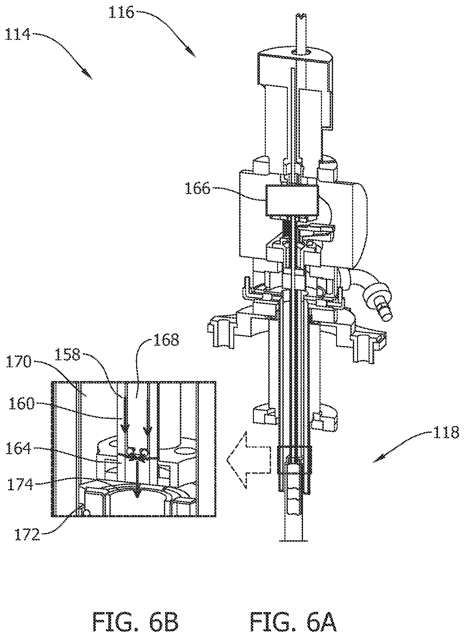

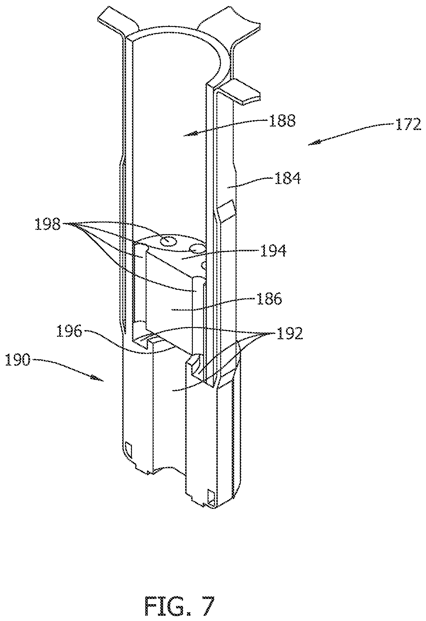

An example ingot puller apparatus 100 is generally shown in FIGS. 1-7. The apparatus 100 of FIGS. 1-7 may be used to counter-dope or dope the ingot with a vaporized boron dopant as in the method described herein or may be used with other liquid-phase dopants that may be vaporized below the melting point of silicon (about 1414°C) in either the native form, or a hydrated form, or in a compound that is non-contaminating to the crystal growth process.

Referring now to FIG. 1, the ingot puller apparatus 100 includes an ingot puller outer housing 102 that defines an ingot puller inner chamber 104 within the housing 102. A crucible 106 is disposed within the ingot puller inner chamber 104. The crucible 106 contains the silicon melt 108 from which a silicon ingot 110 is pulled. The ingot 110 is shrouded by a heat shield 112.

The ingot puller apparatus 100 includes a dopant injector 114 for injecting liquid dopant into the ingot puller apparatus as the ingot 110 is pulled from the silicon melt 110. The dopant injector 114 enables the silicon melt 110 to be counter-doped with a liquid dopant multiple times as the ingot 110 is pulled from the melt, increasing the resistivity of the ingot, increasing the portion of the ingot that is within customer specifications (e.g., high resistivity), and increasing the efficiency of the ingot puller apparatus.

The dopant injector 114 includes an injection module 116, a delivery module 118, and a first flange 120. The injection module 116 and the delivery module 118 are each attached to the first flange 120, and the flange attaches the injection module and the delivery module to the housing 102. Specifically, the housing 102 defines a dopant injector opening 122, and the first flange 120 is attached to the housing such that the flange covers the dopant injector opening.

The injection module 116 is attached to a first side 124 of the first flange 120 such that the injection module is positioned outside the chamber 104. The delivery module 118 is attached to a second side 126 of the first flange 120 such that the delivery module is positioned within the chamber 104. The injection module 116 receives dopant and channels the dopant to the delivery module 118, and the delivery module receives dopant from the injection module and injects the dopant into the chamber 104 as described herein. The injection module 116 receives a liquid dopant, and the delivery module 118 vaporizes the liquid dopant within the chamber 104 as described herein.

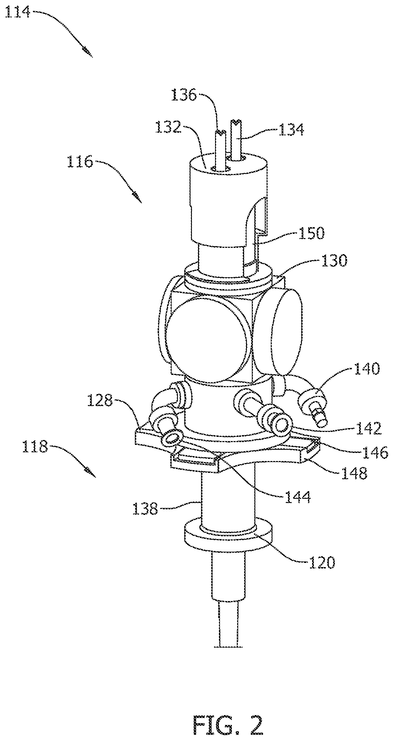

As shown in FIG. 2, the injection module 116 includes a second flange 128, a doping chamber 130 attached to the second flange 128, an actuation mechanism 132 positioned on top of the doping chamber, cooling fluid conduits 134 and 136 for channeling cooling fluid to the dopant injector 114, a bellows 138 attached to the first flange 120 and the second flange 128, and ports 140, 142, and 144 for channeling material into and out of the dopant injector. The doping chamber 130 is attached to a first side 146 of the second flange 128, the bellows 138 is attached to a second side 148 of the second flange 128 and the first side 124 of the first flange 120, and the ports 140, 142, and 144 are attached to and extend from the doping chamber. The bellows 138 enables the injection module 116 to be positioned within the ingot puller inner chamber 104 proximate the silicon melt 110. Specifically, the bellows 138 enables the injection module 116 to be moved vertically relative to the silicon melt 110.

The cooling fluid conduits 134 and 136 include a cooling fluid supply 134 and a cooling fluid return 136. The cooling fluid conduits 134 and 136 extend through the actuation mechanism 132 and into the doping chamber 130. The actuation mechanism 132 includes air cylinders 150 for actuating valves within the dopant injector 114 as described herein. The ports 140, 142, and 144 include an inert gas port 140 for supplying an inert gas to the dopant injector 114, a pressure sensor port 142 for measuring a pressure of the doping chamber 130, and a vacuum port 144 for generating a vacuum within the doping chamber.

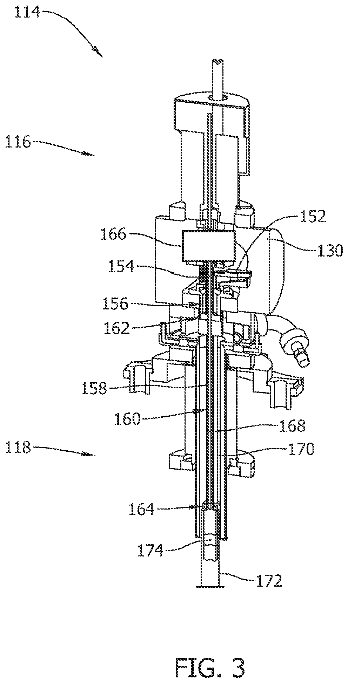

As shown in FIG. 3, the injection module 116 also includes a dopant addition tube 152, a first reservoir tube 154 defining a first reservoir 156, a second reservoir tube 158 partially defining a second reservoir 160, a first valve 162, a second valve 164, an actuator 166, an actuation shaft 168, and a cooling jacket 170. The dopant addition tube 152, the first reservoir tube 154, the first reservoir 156, and the first valve 162 are all positioned within the doping chamber 130. The second reservoir tube 158, the second reservoir 160, the actuation shaft 168, and the cooling jacket 170 all extend from the doping chamber 130. The second reservoir tube 158 circumscribes the actuation shaft 168 to define the second reservoir 160 therebetween, and the cooling jacket 170 circumscribes the second reservoir tube 158.

The dopant addition tube 152 is coupled to the first reservoir 156, and the first valve 162 is selectively actuated by the actuation shaft 168 to maintain or release liquid dopant within the first reservoir. The dopant addition tube 152 receives liquid dopant and channels the liquid dopant to the first reservoir 156. The first valve 162 is closed and maintains the liquid dopant within the first reservoir 156. Upon actuation by the actuation shaft 168, the first valve 162 opens and channels the liquid dopant into the second reservoir 160 as described herein.

The first reservoir 156 is coupled to the second reservoir 160, and the first valve 162 is selectively actuated by the actuation shaft 168 to release liquid dopant within the first reservoir to the second reservoir. The second reservoir 160 receives liquid dopant and channels the liquid dopant to the delivery module 118. The second valve 164 is closed and maintains the liquid dopant within the second reservoir 160. Upon actuation by the actuation shaft 168, the second valve 164 opens and channels the liquid dopant into the delivery module 118 as described herein. The cooling jacket 170 receives a cooling fluid from the cooling fluid supply 134 and returns the cooling fluid to the cooling fluid return 136. The cooling fluid cools the injection module 116 to prevent the injection module from overheating.

The ingot puller inner chamber 104 is maintained at a first pressure, and the doping chamber 130 is maintained at a second pressure greater than the first pressure. Specifically, the first pressure of the ingot puller inner chamber 104 is maintained at a vacuum, and the second pressure of the doping chamber 130 is maintained at atmospheric pressure such that the liquid dopant is also maintained at atmospheric pressure. In alternative embodiments, the first pressure of the ingot puller inner chamber 104 is maintained at a pressure below atmospheric pressure, and the second pressure of the doping chamber 130 is maintained at a pressure above the first pressure. Accordingly, the liquid dopant is maintained at the second pressure (atmospheric pressure) until the liquid dopant is injected into the ingot puller inner chamber 104 where the pressure of the liquid dopant is reduced to the first pressure (a vacuum).

The actuator 164 is positioned within the doping chamber 130 and is coupled to the air cylinders 150 and the actuation shaft 168. The air cylinders 150 actuate the actuator 160, and the actuator actuates the first valve 162 and the actuation shaft 168. The actuation shaft 168 actuates the second valve 164. More specifically, in the illustrated embodiment, the actuator 160 is a liner actuator that translates the first valve 162 and the shaft 168 linearly to translate open the first valve and to translate the second valve 164 linearly to open the second valve. In alternative embodiments, the actuation shaft 168 is coupled to both the first valve 162 and the second valve 164 and actuates both the first valve and the second valve. In some embodiments, the actuation shaft 168 independently actuates the first valve 162 and the second valve 164. In alternative embodiments, the actuation shaft 168 actuates the first valve 162 and the second valve 164 simultaneously. For example, the actuation shaft 168 may actuate the first valve 162 and the second valve 164 simultaneously such that the first valve 162 is closed when the second valve 164 is open and the first valve 162 is open when the second valve 164 is closed in order to maintain the first pressure within the ingot puller inner chamber 104.

The delivery module 118 includes a feed tube 172 and a vaporization cup 174 positioned within the feed tube. The feed tube 172 is positioned within the ingot puller inner chamber 104 and channels vaporized dopant to the silicon melt 108. Specifically, the vaporization tube 174 is heated by radiant heat from within the ingot puller inner chamber 104 and receives the liquid dopant from the second reservoir 160. The ingot puller apparatus 100 includes a heating system 176 that melts the silicon melt 108 and radiates heat into the ingot puller inner chamber 104. The liquid dopant is vaporized into a vaporized dopant within the ingot puller inner chamber 104 where the liquid dopant is vaporized by flash evaporation by heating the liquid dopant with the vaporization cup 174 and reducing the pressure of the liquid dopant from the second pressure to the first pressure by injecting the liquid dopant into the ingot puller inner chamber 104.

The feed tube 172 has a distal end 178 furthest from the ingot puller outer housing 102 and a proximal end 180 nearest the ingot puller outer housing. A feed tube axis A extends through the distal end 178 and the proximal end 180 of the feed tube 172. The feed tube 172 may be made of quartz or other suitable materials.

The feed tube 172 is moveable within the ingot puller inner chamber 104 along the feed tube axis A. The feed tube 172 may be lowered into the ingot puller inner chamber 104 toward the silicon melt 108. Specifically, the feed tube 172 is attached to the cooling jacket 170, and the cooling jacket is attached to the doping chamber 130. The bellows 138 enables the doping chamber 130, the cooling jacket 170, and the feed tube 172 to move along the feed tube axis A toward and away from the silicon melt 108. By moving the doping chamber 130, the cooling jacket 170, and the feed tube 172, the distal end 178 of the feed tube 172 moves between a raised position in which the distal end positioned away from the silicon melt 108 and a lowered position in which the distal end is positioned proximate the surface of the silicon melt 108. The heat shield 112 may include a channel 182 formed therein to provide a pathway for the feed tube 172 to approach the silicon melt 108.

In the lowered position of the feed tube 172, the vaporized dopant travels down the feed tube where it is directed to the surface of the silicon melt 108. The vaporized dopant passes through the distal end 178 of the feed tube 172 to contact the silicon melt 108 to cause the silicon melt to be doped and/or counter doped. As the doping chamber 130, the cooling jacket 170, and the feed tube 172 are moved from the raised position to the lower position, the distance between the vaporization cup 174 and the silicon melt 108 and the heating system 176 may be changed (e.g., by an operator).

The vaporization cup 174 includes a receiver 184 and a vaporization plug 186 positioned within the receiver and divides the receiver into a liquid reception portion 188 and a vapor channel portion 190. The receiver 184 and the vaporization plug 186 define the liquid reception portion 188, and the receiver 184 defines channels 192 that channel vaporized dopant from the liquid reception portion to the feed tube 172. The vaporization plug 186 has a first end 194 and a second end 196 and defines vaporization channels 198 extending from the first end to the second end that channel vaporized dopant from the liquid reception portion 188 to the vapor channel portion 190.

Excess heat from the heating system 176 heats the vaporization plug 186, and the second valve 164 channels the liquid dopant from the second reservoir 160 into the liquid reception portion 188 and onto the vaporization plug. The vaporization plug 186 vaporizes the liquid dopant into vaporized dopant by flash evaporation by heating the liquid dopant with the vaporization plug 186 and reducing the pressure of the liquid dopant from the second pressure to the first pressure by injecting the liquid dopant into the liquid reception portion 188. The vaporization channels 198 channel the vaporized dopant into the channels 192 of the vapor channel portion 190 which channel the vaporized dopant into the feed tube 172 and to the silicon melt 108. Additionally, a process gas (e.g., argon) may be circulated through the doping chamber 130 through the inert gas port 140 for channeling the vaporized dopant through the vaporization cup 174 and the feed tube 172.

The pressure sensor port 142 enables measurement of the pressure within the ingot puller inner chamber 104. The vacuum port 144 enables pump-down and leak testing. The cooling jacket 170 cools the injection module 116 to prevent the injection module from overheating

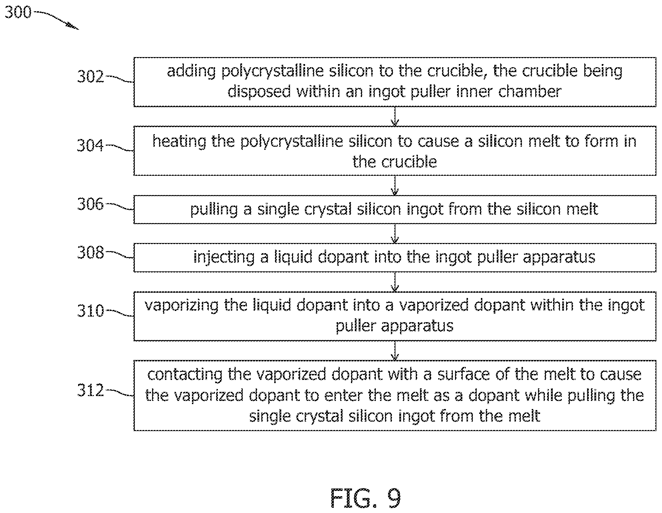

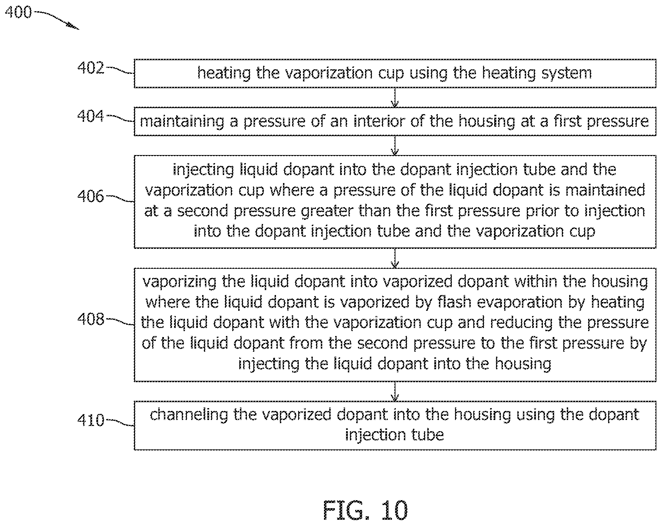

Example methods of the present invention are shown in FIGS. 9 and 10. The method may be carried out by use of the ingot puller apparatus 100 that is configured to produce a boron-containing gas from liquid-phase boric acid.

In accordance with embodiments of the method for preparing a silicon ingot, a silicon melt is prepared in the crucible 106 disposed within the ingot puller inner chamber 104 of the ingot puller apparatus 100. The crucible 106 may be supported by a susceptor (not shown). The ingot puller apparatus 100 may be configured to rotate the crucible 106 and/or move the crucible 106 vertically within the ingot puller apparatus 100.

To prepare the silicon melt, polycrystalline silicon is added to the crucible 106. The polycrystalline silicon is heated to above the melting temperature of silicon (about 1414°C) to cause the polycrystalline silicon to liquefy into the silicon melt 108. The heating system 176 is operated to melt-down the polycrystalline silicon. For example, one or more heaters 200 below or to the side of the crucible 106 are operated to melt-down the silicon.

Before or after the melt 108 is produced, the melt may be doped with a dopant, typically an n-type dopant, to compensate for p-type impurities (e.g., boron) in the melt. The n-type dopant may be added before growth of the ingot 110 commences. By compensating the melt, the resistivity of the resulting ingot 110 may be increased. For example, the seed end of the ingot (i.e., the portion of the ingot nearest the ingot crown) may have a resistivity of at least about 30 Ω-cm or, as in other embodiments, at least about 35 Ω-cm, at least about 40 Ω-cm, at least about 45 Ω-cm, at least about 50 Ω-cm, at least about 55 Ω-cm, at least about 60 Ω-cm or from about 30 Ω-cm to about 60 ohm-cm. Suitable n-type dopants include phosphorous and arsenic.

Once the melt 108 is prepared, the single crystal silicon ingot 110 is pulled from the melt 108. A seed crystal 202 is secured to a seed chuck 204. The seed chuck 204 and seed crystal 202 are lowered until the seed crystal 202 contacts the surface of the silicon melt 108. Once the seed crystal 202 begins to melt, a pulling mechanism slowly raises the seed crystal 202 up to grow the monocrystalline ingot 110. A process gas (e.g., argon) is circulated through the ingot puller inner chamber 104 of the ingot puller apparatus 100. The process gas creates an atmosphere within the ingot puller inner chamber 104.

Embodiments of methods of the present invention include providing a source of liquid-phase boric acid (H₃BO₃). The boric acid may be relatively pure such as about 99% pure or more, 99.9% pure or more, or 99.99% pure or more. In some embodiments, the boric acid may be relatively isotopically pure (i.e., boron-11).

A boron-containing gas is produced from the liquid-phase boric acid. The gas that is produced is generally in the form of boric acid (H₃BO₃) or derivatives thereof (BₓO_{y}H_{z}⁺ complexes) and not other compounds (e.g., diborane (B₂H₆) or boron dihydride (BH₂)) . However, it should be understood that other boron compounds may be added to the boron-containing gas.

The liquid-phase boric acid may be heated to above its vaporization temperature (about 300°C) to produce a boron-containing gas. For example, the liquid-phase boric acid may be heated by heat radiated from the silicon melt 108 in the ingot puller apparatus 100 or by the heating system 176.

Once the boron-containing gas is produced, the boron-containing gas contacts the surface of the silicon melt 108 to allow boron to diffuse into the melt. Once boron enters the melt, boron compensates for phosphorous which has concentrated in the melt due to the relatively low segregation coefficient of phosphorous, thereby increasing the resistivity of the remaining portion of the ingot 110 that forms in the ingot puller apparatus 100.

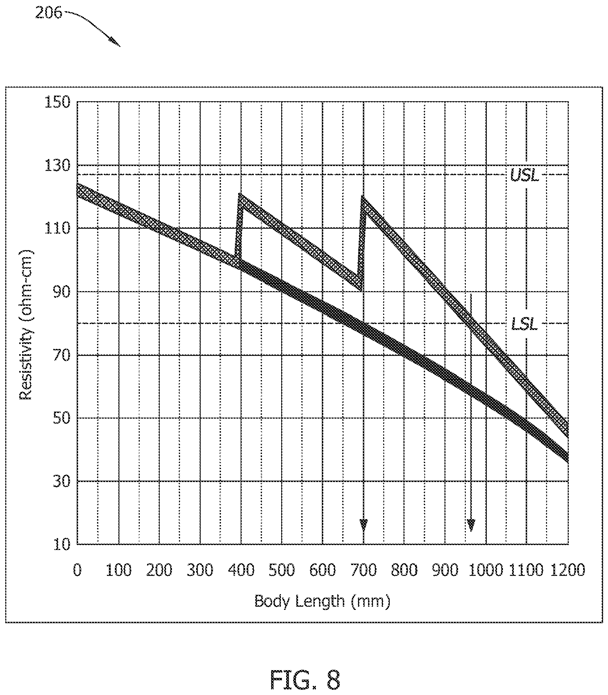

FIG. 8 is a graph 206 of ingot resistivity as a function of ingot length. As shown in FIG. 8, the silicon melt 108 may be counter-doped as described herein multiple times as the ingot 110 is pulled from the silicon melt. Specifically, the resistivity of the ingot 110 may decrease as the ingot is pulled from the silicon melt 108 because of the concentration of phosphorous. The silicon melt 108 may be counter-doped with the dopant injector 114 as described herein multiple times as the ingot 110 is pulled from the silicon melt 108 to increase the resistivity of the ingot during production such that a larger portion of the ingot is within customer specifications (e.g., high resistivity). More specifically, as shown in FIG. 8, the silicon melt 108 is counter-doped twice as the ingot 110 is pulled from the silicon melt 108. Accordingly, the dopant injector 114 increases the efficiency of the ingot puller apparatus 100 by counter-doping the silicon melt 108 multiple times during production of the ingot 110 and maintaining the resistivity of a larger portion of the ingot within customer specifications (e.g., high resistivity).

FIG. 9 is a flow diagram of a method 300 for producing a single crystal silicon ingot from a silicon melt held within a crucible positioned within an ingot puller apparatus. The method 300 includes adding 302 polycrystalline silicon to the crucible, and the crucible is disposed within an ingot puller inner chamber. The method 300 also includes heating 304 the polycrystalline silicon to cause a silicon melt to form in the crucible. The method 300 further includes pulling 306 a single crystal silicon ingot from the silicon melt. The method 300 also includes injecting 308 a liquid dopant into the ingot puller apparatus. The method 300 further includes vaporizing 310 the liquid dopant into a vaporized dopant within the ingot puller apparatus. The method 300 also includes contacting 312 the vaporized dopant with a surface of the melt to cause the vaporized dopant to enter the melt as a dopant while pulling the single crystal silicon ingot from the melt.

FIG. 10 is a flow diagram of a method 400 for doping a single crystal silicon ingot pulled from a silicon melt held within a crucible positioned within an ingot puller apparatus. The ingot puller apparatus includes a housing, a dopant injector extending into the housing, and a heating system positioned with the housing. The dopant injector includes a dopant injection tube positioned within the housing and a vaporization cup positioned within the dopant injection tube and the housing. The method 400 includes heating 402 the vaporization cup using the heating system. The method 400 also includes maintaining 404 a pressure of an interior of the housing at a first pressure. The method 400 further includes injecting 406 liquid dopant into the dopant injection tube and the vaporization cup. A pressure of the liquid dopant is maintained at a second pressure greater than the first pressure prior to injection into the dopant injection tube and the vaporization cup. The method 400 also includes vaporizing 408 the liquid dopant into vaporized dopant within the housing. The liquid dopant is vaporized by flash evaporation by heating the liquid dopant with the vaporization cup and reducing the pressure of the liquid dopant from the second pressure to the first pressure by injecting the liquid dopant into the housing. The method 400 further includes channeling 410 the vaporized dopant into the housing using the dopant injection tube.

Compared to conventional methods for producing a single crystal silicon ingot from a silicon melt, the systems and methods of the present invention have several advantages. Specifically, a larger portion of the ingot may be within customer specifications (e.g., high resistivity) and/or a type-change in the ingot may be prevented. More specifically, the systems and methods of the present invention control the rate of doping such that compensating boron is incorporated into the ingot to neutralize the effect of segregation by phosphorous. Thus, the net free charge carriers may be maintained between limits over the length of the ingot. Depending on the target resistivity of the ingot, controlling the rate of doping may prevent a type change of the ingot from n-type to p-type or in other examples, from p-type to n-type. Liquid-phase boric acid has a relatively low vaporization temperature which allows a dopant gas to be produced with relative ease. Additionally, the vaporization cup may be placed within ingot puller housing which allows the heat of the melt and the heating system to vaporize the dopant. The feed tube is moveable within the ingot puller apparatus such that the distance from the melt may be controlled which allows the rate of dopant addition to the melt to be controlled. Accordingly, the systems and methods described herein increases the efficiency of the ingot puller apparatus by counter-doping the silicon melt multiple times during production of the ingot and maintaining the resistivity of a larger portion of the ingot within customer specifications (e.g., high resistivity).

As used herein, the term "about" when used in conjunction with ranges of dimensions, concentrations, temperatures or other physical or chemical properties or characteristics is meant to cover variations that may exist in the upper and/or lower limits of the ranges of the properties or characteristics, including, for example, variations resulting from rounding, measurement methodology or other statistical variation.

When introducing elements of the present invention or the embodiment(s) thereof, the articles "a", "an", "the" and "said" are intended to mean that there are one or more of the elements. The terms "comprising," "including," "containing" and "having" are intended to be inclusive and mean that there may be additional elements other than the listed elements. The use of terms indicating a particular orientation (e.g., "top", "bottom", "side", etc.) is for convenience of description and does not require any particular orientation of the item described.

## Claims

1. An ingot puller apparatus (100) for producing a doped single crystal silicon ingot, the ingot puller apparatus comprising:
a housing (102) defining a chamber (104);
a crucible (106) disposed within the chamber; and
a dopant injector (114) extending into the housing, the dopant injector comprising:
a delivery module (118) attached to and extending through the housing into the chamber, the delivery module comprising:
a dopant injection tube (172) positioned within the chamber; and
a vaporization cup (174) positioned within the dopant injection tube and the chamber, wherein a valve (164) selectively channels the liquid dopant into the vaporization cup and the vaporization cup vaporizes the liquid dopant into a vaporized dopant.

2. The ingot puller apparatus as set forth in claim 1, wherein the dopant injector comprises an injection module (116) attached to an outer surface of the housing, the injection module comprising:
a first reservoir (156) for containing a liquid dopant;
a second reservoir (160) for containing the liquid dopant;
a first valve (162) for selectively channeling the liquid dopant from the first reservoir to the second reservoir; and
a second valve (164) for selectively channeling the liquid dopant from the second reservoir to the chamber;
wherein the delivery module is attached to the injection module, wherein the second valve (164) selectively channels the liquid dopant into the vaporization cup.

3. An ingot puller apparatus (100) for producing a doped single crystal silicon ingot, the ingot puller apparatus comprising:
a housing (102) defining a chamber (104);
a crucible (106) disposed within the chamber; and
a dopant injector (114) extending into the housing, the dopant injector comprising:
an injection module (116) attached to an outer surface of the housing, the injection module comprising:
a first reservoir (156) for containing a liquid dopant;
a second reservoir (160) for containing the liquid dopant;
a first valve (162) for selectively channeling the liquid dopant from the first reservoir to the second reservoir; and
a second valve (164) for selectively channeling the liquid dopant from the second reservoir to the chamber; and
a delivery module (118) attached to the injection module and extending through the housing into the chamber, wherein the second valve (164) selectively channels the liquid dopant into the delivery module and the delivery module vaporizes the liquid dopant into a vaporized dopant.

4. The ingot puller apparatus as set forth in any one of claims 1 and 2
wherein the dopant injection tube includes a first end positioned proximate a surface of a melt to direct the vaporized dopant to the surface.

5. The ingot puller apparatus as set forth in any one of claims 1 and 2
wherein the vaporization cup (174) comprises:
a receiver (184); and
a vaporization plug (186) positioned within the receiver, wherein the liquid dopant is injected onto the vaporization plug and the vaporization plug vaporizes the liquid dopant into the vaporized dopant.

6. The ingot puller apparatus as set forth in claim 5 wherein:
the vaporization plug (186) divides the receiver (184) into a liquid reception portion (188) and a vapor channel portion (190);
the receiver (184) defines channels that channel the vaporized dopant from the liquid reception portion to the dopant injection tube; and
the vaporization plug includes a first end (194) and a second end (196) and defines vapor channels (198) extending from the first end to the second end, wherein the liquid dopant is injected onto the vaporization plug and the vaporized dopant is channeled into the channels through the vapor channels.

7. The ingot puller apparatus as set forth in any one of claims 1 and 2
wherein the dopant injector includes a bellows (138) for moving the dopant injection tube (172) proximate a silicon melt in the crucible.

8. The ingot puller apparatus as set forth in any one of claims 1 and 2 further comprising a heating system (176) for heating the vaporization cup using radiant heat from the heating system, wherein the radiant heat from the heating system is excess heat from the heating system as the heating system melts polycrystalline silicon in the crucible.

9. The ingot puller apparatus as set forth in any one of claims 2 to 3, further comprising a shaft (168) coupled to the second valve, wherein the shaft actuates the second valve.

10. The ingot puller apparatus as set forth in any one of claims 2 to 3,
wherein the first reservoir and the second reservoir are maintained at a pressure above a pressure of the chamber.

11. A method for producing a single crystal silicon ingot from a silicon melt held within a crucible (106) positioned within an ingot puller apparatus (100), wherein the ingot puller apparatus includes a dopant injector (114) extending into a housing (102) of the ingot puller apparatus, the dopant injector including a first reservoir (156), a first valve (162), a second reservoir (160), a second valve (164), a dopant injection tube (172) positioned within the housing, and a vaporization cup (174) positioned within the dopant injection tube and the housing, the method comprising:
adding polycrystalline silicon to the crucible, the crucible being disposed within an ingot puller inner chamber;
heating the polycrystalline silicon to cause a silicon melt to form in the crucible;
pulling a single crystal silicon ingot from the silicon melt;
injecting a liquid dopant into the ingot puller apparatus by:
channeling the liquid dopant from the first reservoir to the second reservoir by opening the first valve; and
channeling the liquid dopant from the second reservoir to the housing by opening the second valve;
vaporizing the liquid dopant into a vaporized dopant within the ingot puller apparatus by:
heating the liquid dopant using the vaporization cup; and
reducing a pressure of the liquid dopant by injecting the liquid dopant into the housing, wherein the housing is maintained at a pressure below atmospheric pressure; and
contacting the vaporized dopant with a surface of the melt to cause the vaporized dopant to enter the melt as a dopant while pulling the single crystal silicon ingot from the melt.

12. A method for doping a single crystal silicon ingot pulled from a silicon melt held within a crucible (106) positioned within an ingot puller apparatus (100), wherein the ingot puller apparatus includes a housing (102), a dopant injector (114) extending into the housing, and a heating system (176) positioned with the housing, the dopant injector including a dopant injection tube (172) positioned within the housing and a vaporization cup (174) positioned within the dopant injection tube and the housing, the method comprising:
heating the vaporization cup using the heating system;
injecting liquid dopant into the dopant injection tube and the vaporization cup;
vaporizing the liquid dopant into vaporized dopant within the housing, wherein the liquid dopant is vaporized by flash evaporation by heating the liquid dopant with the vaporization cup; and
channeling the vaporized dopant into the housing using the dopant injection tube.

13. The method as set forth in claim 12, wherein a pressure of an interior of the housing is maintained at a first pressure; wherein a pressure of the liquid dopant is maintained at a second pressure greater than the first pressure prior to injection of the liquid dopant into the dopant injection tube and the vaporization cup; and wherein the liquid dopant is vaporized by flash evaporation by heating the liquid dopant with the vaporization cup and reducing the pressure of the liquid dopant from the second pressure to the first pressure by injecting the liquid dopant into the housing.

14. The method as set forth in claim 12 or claim 13, wherein heating the vaporization cup comprises heating the vaporization cup using radiant heat from the heating system, wherein the radiant heat from the heating system is excess heat from the heating system as the heating system melts polycrystalline silicon in the crucible.

15. The method as set forth in claim 11 or claim 13 further comprising channeling an inert gas into the dopant injection tube, wherein the inert gas channels the vaporized dopant into the housing.

16. The method as set forth in claim 13, wherein the first pressure is a pressure below atmospheric pressure, or wherein the first pressure is a vacuum and the second pressure is atmospheric pressure.

17. The method as set forth in claim 13 further comprising diffusing the vaporized dopant into the silicon melt.

18. The method as set forth in claim 12, wherein the vaporization cup includes a receiver (184) and a vaporization plug (186) positioned within the receiver, and wherein heating the vaporization cup using the heating system comprises heating the vaporization plug positioned within the receiver.

19. The method as set forth in claim 11, wherein the dopant injector includes a bellows (138), wherein injecting a liquid dopant into the ingot puller apparatus comprises:
moving the dopant injection tube proximate the silicon melt using the bellows; and
diffusing the vaporized dopant into the silicon melt.

20. The method as set forth in claim 11 further comprising heating the vaporization cup using radiant heat from a heating system (176), wherein the radiant heat from the heating system is excess heat from the heating system as the heating system melts polycrystalline silicon in the crucible.

21. The method as set forth in claim 11, wherein the first reservoir and the second reservoir are maintained at a pressure above the pressure of the housing, optionally wherein the pressure of the housing is a vacuum and the pressure of the first reservoir and the second reservoir is atmospheric pressure.

22. The method as set forth in claim 11, wherein the vaporization cup includes a receiver (184) and a vaporization plug (186) positioned within the receiver, and wherein heating the liquid dopant using the vaporization cup comprises:
heating the vaporization plug positioned within the receiver; and
heating the liquid dopant using the vaporization plug.

23. The method as set forth in claim 12, wherein the dopant injector includes a first reservoir (156), a first valve (162), a second reservoir (160), and a second valve (164), wherein injecting a liquid dopant into the ingot puller apparatus comprises:
channeling the liquid dopant from the first reservoir to the second reservoir by opening the first valve; and
channeling the liquid dopant from the second reservoir to the housing by opening the second valve.

## Patentansprüche

1. Eine Ingotziehapparatur (100) zur Herstellung eines dotierten Siliciumeinkristall-Ingots, die Ingotziehapparatur umfassend:
ein Gehäuse (102), welches eine Kammer umschließt (104);
einen in der Kammer befindlichen Tiegel (106); und
einen Dotiermittel-Injektor (114), der sich in das Gehäuse erstreckt, der Dotiermittel-Injektor umfassend:
ein Abgabemodul (118), welches am Gehäuse befestigt ist und sich durch das Gehäuse in die Kammer erstreckt, das Abgabemodul umfassend:
eine Dotiermittel-Injektionsleitung (172), welche innerhalb der Kammer positioniert ist; und
einen Verdampfungsbecher (174), welcher innerhalb der Dotiermittel-Injektionsleitung und der Kammer positioniert ist, wobei ein Ventil (164) das flüssige Dotiermittel selektiv in den Verdampfungsbecher leitet und der Verdampfungsbecher das flüssige Dotiermittel zu einem vaporisierten Dotiermittel verdampft.

2. Die Ingotziehapparatur gemäß Anspruch 1, wobei der Dotiermittel-Injektor ein Injektionsmodul (116) umfasst, welches an einer Außenfläche des Gehäuses befestigt ist, das Injektionsmodul umfassend:
ein erstes Reservoir (156) für ein flüssiges Dotiermittel;
ein zweites Reservoir (160) für das flüssige Dotiermittel;
ein erstes Ventil (162) um das flüssige Dotiermittel selektiv vom ersten Reservoir zum zweiten Reservoir zu leiten; und
ein zweites Ventil (164) um das flüssige Dotiermittel selektiv vom zweiten Reservoir zur Kammer zu leiten;
wobei das Abgabemodul am Injektionsmodul befestigt ist, wobei das zweite Ventil (164) das flüssige Dotiermittel selektiv in den Verdampfungsbecher leitet.

3. Eine Ingotziehapparatur (100) zur Herstellung eines dotierten Siliciumeinkristall-Ingots, die Ingotziehapparatur umfassend:
ein Gehäuse (102), welches eine Kammer umschließt (104);
einen in der Kammer befindlichen Tiegel (106); und
einen Dotiermittel-Injektor (114), der sich in das Gehäuse erstreckt, der Dotiermittel-Injektor umfassend:
ein Injektionsmodul (116), welches an einer Außenfläche des Gehäuses befestigt ist, das Injektionsmodul umfassend:
ein erstes Reservoir (156) für ein flüssiges Dotiermittel;
ein zweites Reservoir (160) für das flüssige Dotiermittel;
ein erstes Ventil (162) um das flüssige Dotiermittel selektiv vom ersten Reservoir zum zweiten Reservoir zu leiten; und
ein zweites Ventil (164) um das flüssige Dotiermittel selektiv vom zweiten Reservoir zur Kammer zu leiten; und
ein Abgabemodul (118), welches am Injektionsmodul befestigt ist und sich durch das Gehäuse in die Kammer erstreckt, wobei das zweite Ventil (164) das flüssige Dotiermittel selektiv in das Abgabemodul leitet und das Abgabemodul das flüssige Dotiermittel zu einem vaporisierten Dotiermittel verdampft.

4. Die Ingotziehapparatur gemäß irgendeinem der Ansprüche 1 und 2, wobei die Dotiermittel-Injektionsleitung ein erstes Ende hat, welches nahe einer Oberfläche einer Schmelze positioniert ist, um das vaporisierte Dotiermittel zu der Oberfläche zu dirigieren.

5. Die Ingotziehapparatur gemäß irgendeinem der Ansprüche 1 und 2, wobei der Verdampfungsbecher (174) umfasst:
einen Aufnahmebehälter (184); und
einem im Aufnahmebehälter positionierten Verdampfungsstopfen (186), wobei das flüssige Dotiermittel auf den Verdampfungsstopfen injiziert wird und der Verdampfungsstopfen das flüssige Dotiermittel zum vaporisierten Dotiermittel verdampft.

6. Die Ingotziehapparatur gemäß Anspruch 5, wobei:
der Verdampfungsstopfen (186) den Aufnahmebehälter (184) in einen Teil zur Flüssigkeitsaufnahme (188) und einen Teil zur Kanalisierung des Dampfs (190) unterteilt;
der Aufnahmebehälter (184) Kanäle definiert, welche das vaporisierte Dotiermittel aus dem Teil zur Flüssigkeitsaufnahme in die Dotiermittel-Injektionsleitung kanalisieren; und
der Verdampfungsstopfen ein erstes Ende (194) und ein zweites Ende (196) hat und Dampfkanäle (198) definiert, welches ich vom ersten zum zweiten Ende erstrecken, wobei das flüssige Dotiermittel auf den Verdampfungsstopfen injiziert wird und das vaporisierte Dotiermittel durch die Dampfkanäle in die Kanäle geleitet wird.

7. Die Ingotziehapparatur gemäß irgendeinem der Ansprüche 1 und 2, wobei der Dotiermittel-Injektor einen Balg (138) umfasst, um die Dotiermittel-Injektionsleitung (172) in die Nähe einer Siliciumschmelze im Tiegel zu bewegen.

8. Die Ingotziehapparatur gemäß irgendeinem der Ansprüche 1 und 2, außerdem umfassend ein Heizsystem (176), um den Verdampfungsbecher mittels Hitzestrahlung vom Heizsystem zu erhitzen, wobei die Hitzestrahlung vom Heizsystem Überschusshitze vom Heizsystem ist, welche produziert wird, während das Heizsystem polykristallines Silicium im Tiegel schmilzt.

9. Die Ingotziehapparatur gemäß irgendeinem der Ansprüche 2 bis 3, außerdem umfassend einen Schaft (168), der an das zweite Ventil gekoppelt ist, wobei der Schaft das zweite Ventil betätigt.

10. Die Ingotziehapparatur gemäß irgendeinem der Ansprüche 2 bis 3, wobei das erste Reservoir und das zweite Reservoir unter einem Druck gehalten werden, welcher höher ist als der Druck in der Kammer.

11. Ein Verfahren zur Herstellung eines Siliciumeinkristall-Ingots aus einer Siliciumschmelze in einem Tiegel (106), der sich in einer Ingotziehapparatur (100) befindet, wobei die Ingotziehapparatur eine Dotiermittel-Injektor (114) umfasst, welcher sich in ein Gehäuse (102) der Ingotziehapparatur erstreckt, der Dotiermittel-Injektor umfassend ein erstes Reservoir (156), ein erstes Ventil (162), ein zweites Reservoir (160), ein zweites Ventil (164), eine Dotiermittel-Injektionsleitung (172), welche im Gehäuse positioniert ist, und einen Verdampfungsbecher (174), welcher innerhalb der Dotiermittel-Injektionsleitung und dem Gehäuse positioniert ist, das Verfahren umfassend:
Geben von polykristallinem Silicium in den Tiegel, wobei sich der Tiegel in der Innenkammer des Ingotziehers befindet;
Erhitzen des polykristallinen Siliciums, um eine Siliciumschmelze im Tiegel zu erzeugen;
Ziehen eines Siliciumeinkristall-Ingots aus der Siliciumschmelze;
Injektion eines flüssigen Dotiermittels in die Ingotziehapparatur durch:
Leiten des flüssigen Dotiermittels vom ersten Reservoir zum zweiten Reservoir durch Öffnen des ersten Ventils; und
Leiten des flüssigen Dotiermittels vom zweiten Reservoir zum Gehäuse durch Öffnen des zweiten Ventils;
Verdampfen des flüssigen Dotiermittels zu einem vaporisierten Dotiermittel innerhalb der Ingotziehapparatur durch:
Erhitzen des flüssigen Dotiermittels mittels des Verdampfungsbechers; und
Reduktion eines Drucks des flüssigen Dotiermittels durch Injektion des flüssigen Dotiermittels in das Gehäuse, wobei der Druck im Gehäuse auf einem Druck unterhalb Atmosphärendruck gehalten wird; und
Kontaktieren des vaporisierten Dotiermittels mit einer Oberfläche der Schmelze, um ein Eindringen des vaporisierten Dotiermittels in die Schmelze als Dotiermittel zu ermöglichen, während der Siliciumeinkristall-Ingot aus der Schmelze gezogen wird.

12. Ein Verfahren zur Herstellung eines Siliciumeinkristall-Ingots aus einer Siliciumschmelze in einem Tiegel (106), der sich in einer Ingotziehapparatur (100) befindet, wobei die Ingotziehapparatur ein Gehäuse (102), einen sich in das Gehäuse erstreckenden Dotiermittel-Injektor (114) und ein im Gehäuse positioniertes Heizsystem (176) umfasst, wobei der Dotiermittel-Injektor eine im Gehäuse positionierte Dotiermittel-Injektionsleitung (172) und einen Verdampfungsbecher (174) umfasst, welcher innerhalb der Dotiermittel-Injektionsleitung und der Kammer positioniert ist, das Verfahren umfassend:
Erhitzen des Verdampfungsbechers mittels des Heizsystems;
Injektion von flüssigem Dotiermittel in die Dotiermittel-Injektionsleitung und den Verdampfungsbecher;
Verdampfen des flüssigen Dotiermittels zu vaporisiertem Dotiermittel innerhalb des Gehäuses, wobei das flüssige Dotiermitte durch Flash-Evaporation mittels Erhitzen des flüssigen Dotiermittels mit dem Verdampfungsbecher verdampft wird; und
Einleiten des vaporisierten Dotiermittels in das Gehäuse mittels der Dotiermittel-Inj ektionsleitung.

13. Das Verfahren gemäß Anspruch 12, wobei ein Druck im Innenraum des Gehäuses auf einem ersten Druck gehalten wird; wobei ein Druck des flüssigen Dotiermittels auf einem zweiten Druck gehalten wird, welcher vor der Injektion des flüssigen Dotiermittels in die Dotiermittel-Injektionsleitung und den Verdampfungsbecher höher ist als der erste Druck; und wobei das flüssige Dotiermittel durch Flash-Evaporation verdampft wird durch Erhitzen des flüssigen Dotiermittels mit dem Verdampfungsbecher und Reduktion des Drucks des flüssigen Dotiermittels vom zweiten Druck auf den ersten Druck durch Injektion des flüssigen Dotiermittels in das Gehäuse.

14. Das Verfahren gemäß Anspruch 12 oder Anspruch 13, wobei das Erhitzen des Verdampfungsbechers umfasst das Erhitzen des Verdampfungsbechers mittels Heizstrahlung vom Heizsystem, wobei die Hitzestrahlung vom Heizsystem Überschusshitze vom Heizsystem ist, welche produziert wird, während das Heizsystem polykristallines Silicium im Tiegel schmilzt.

15. Das Verfahren gemäß Anspruch 11 oder Anspruch 13, außerdem umfassend das Einleiten eines Inertgases in die Dotiermittel-Injektionsleitung, wobei das Inertgas das vaporisierte Dotiermittel in das Gehäuse leitet.

16. Das Verfahren gemäß Anspruch 13, wobei der erste Druck ein Druck unterhalb Atmosphärendruck ist, oder wobei der erste Druck ein Vakuum ist und der zweite Druck Atmosphärendruck ist.

17. Das Verfahren gemäß Anspruch 13, außerdem umfassend die Diffusion des vaporisierten Dotiermittels in die Siliciumschmelze.

18. Das Verfahren gemäß Anspruch 12, wobei der Verdampfungsbecher einen Aufnahmebehälter (184) und einen im Aufnahmebehälter positionierten Verdampfungsstopfen (186) umfasst, und wobei das Erhitzen des Verdampfungsbechers mittels des Heizsystems das Erhitzen des im Aufnahmebehälter positionierten Verdampfungsstopfens umfasst.

19. Das Verfahren gemäß Anspruch 11, wobei der Dotiermittelinjektor einen Balg (138) umfasst, wobei die Injektion eines flüssigen Dotiermittels in die Ingotziehapparatur umfasst:
Bewegen der Dotiermittel-Injektionsleitung in die Nähe der Siliciumschmelze mittels des Balgs; und
Diffusion des vaporisierten Dotiermittels in die Siliciumschmelze.

20. Das Verfahren gemäß Anspruch 11, außerdem umfassend das Erhitzen des Verdampfungsbechers mittels Heizstrahlung von einem Heizsystem (176), wobei die Hitzestrahlung vom Heizsystem Überschusshitze vom Heizsystem ist, welche produziert wird, während das Heizsystem polykristallines Silicium im Tiegel schmilzt.

21. Das Verfahren gemäß Anspruch 11, wobei das erste Reservoir und das zweite Reservoir unter einem Druck gehalten werden, welcher höher ist als der Druck im Gehäuse, optional wobei der Druck im Gehäuse ein Vakuum ist und der Druck im ersten Reservoir und im zweiten Reservoir Atmosphärendruck ist.

22. Das Verfahren gemäß Anspruch 11, wobei der Verdampfungsbecher einen Aufnahmebehälter (184) und einen im Aufnahmebehälter positionierten Verdampfungsstopfen (186) umfasst, und wobei das Erhitzen des flüssigen Dotiermittels mittels des Verdampfungsbechers umfasst:
Erhitzen des im Aufnahmebehälter positionierten Verdampfungsstopfens; und
Erhitzen des flüssigen Dotiermittels mittels des Verdampfungsstopfens.

23. Das Verfahren gemäß Anspruch 12, wobei der Dotiermittel-Injektor ein erstes Reservoir (156), ein erstes Ventil (162), ein zweites Reservoir (160) und ein zweites Ventil (164) umfasst, wobei die Injektion eines flüssigen Dotiermittels in die Ingotziehapparatur umfasst:
Leiten des flüssigen Dotiermittels vom ersten Reservoir zum zweiten Reservoir durch Öffnen des ersten Ventils; und
Leiten des flüssigen Dotiermittels vom zweiten Reservoir zum Gehäuse durch Öffnen des zweiten Ventils.

## Revendications

1. Appareil d'étirage de lingot (100) pour produire un lingot de silicium monocristallin dopé, l'appareil d'étirage de lingot comportant :
une enceinte (102) définissant une chambre (104),
un creuset (106) disposé à l'intérieur de la chambre, et
un injecteur de dopant (114) s'étendant dans l'enceinte, l'injecteur de dopant comportant :
un module de distribution (118) fixé à et s'étendant à travers l'enceinte dans la chambre, le module de distribution comportant :
un tube d'injection de dopant (172) positionné à l'intérieur de la chambre, et
une coupelle de vaporisation (174) positionnée à l'intérieur du tube d'injection de dopant et de la chambre, dans lequel une soupape (164) canalise sélectivement le dopant liquide dans la coupelle de vaporisation et la coupelle de vaporisation vaporise le dopant liquide en un dopant vaporisé.

2. Appareil d'étirage de lingot selon la revendication 1, dans lequel l'injecteur de dopant comporte un module d'injection (116) fixé à une surface extérieure de l'enceinte, le module d'injection comportant :
un premier réservoir (156) pour contenir un dopant liquide,
un second réservoir (160) pour contenir le dopant liquide,
une première soupape (162) pour canaliser sélectivement le dopant liquide du premier réservoir jusqu'au second réservoir, et
une seconde soupape (164) pour canaliser sélectivement le dopant liquide du second réservoir jusqu'à la chambre,
dans lequel le module de distribution est fixé au module d'injection, dans lequel la seconde soupape (164) canalise sélectivement le dopant liquide dans la coupelle de vaporisation.

3. Appareil d'étirage de lingot (100) pour produire un lingot de silicium monocristallin dopé, l'appareil d'étirage de lingot comportant :
une enceinte (102) définissant une chambre (104),
un creuset (106) disposé à l'intérieur de la chambre, et
un injecteur de dopant (114) s'étendant dans l'enceinte, l'injecteur de dopant comportant :
un module d'injection (116) fixé à une surface extérieure de l'enceinte, le module d'injection comportant :
un premier réservoir (156) pour contenir un dopant liquide,
un second réservoir (160) pour contenir le dopant liquide,
une première soupape (162) pour canaliser sélectivement le dopant liquide du premier réservoir jusqu'au second réservoir, et
une seconde soupape (164) pour canaliser sélectivement le dopant liquide du second réservoir jusqu'à la chambre, et
un module de distribution (118) fixé au module d'injection et s'étendant à travers l'enceinte dans la chambre, dans lequel la seconde soupape (164) canalise sélectivement le dopant liquide dans le module de distribution et le module de distribution vaporise le dopant liquide en un dopant vaporisé.

4. Appareil d'étirage de lingot selon l'une quelconque des revendications 1 et 2, dans lequel le tube d'injection de dopant comprend une première extrémité positionnée près d'une surface d'un bain fondu pour diriger le dopant vaporisé vers la surface.

5. Appareil d'étirage de lingot selon l'une quelconque des revendications 1 et 2, dans lequel la coupelle de vaporisation (174) comporte :
un récepteur (184), et
un bouchon de vaporisation (186) positionné à l'intérieur du récepteur, dans lequel le dopant liquide est injecté sur le bouchon de vaporisation et le bouchon de vaporisation vaporise le dopant liquide en dopant vaporisé.

6. Appareil d'étirage de lingot selon la revendication 5, dans lequel :
le bouchon de vaporisation (186) divise le récepteur (184) en une partie de réception de liquide (188) et une partie de canal de vapeur (190),
le récepteur (184) définit des canaux qui canalisent le dopant vaporisé de la partie de réception de liquide jusqu'au tube d'injection de dopant, et
le bouchon de vaporisation comprend une première extrémité (194) et une seconde extrémité (196) et définit des canaux de vapeur (198) s'étendant de la première extrémité à la seconde extrémité, dans lequel le dopant liquide est injecté sur le bouchon de vaporisation et le dopant vaporisé est canalisé dans les canaux par l'intermédiaire des canaux de vapeur.

7. Appareil d'étirage de lingot selon l'une quelconque des revendications 1 et 2, dans lequel l'injecteur de dopant comprend un soufflet (138) pour déplacer le tube d'injection de dopant (172) près d'un bain de silicium fondu dans le creuset.

8. Appareil d'étirage de lingot selon l'une quelconque des revendications 1 et 2, comportant en outre un système de chauffage (176) pour chauffer la coupelle de vaporisation en utilisant de la chaleur rayonnante provenant du système de chauffage, dans lequel la chaleur rayonnante provenant du système de chauffage est la chaleur en excès provenant du système de chauffage lorsque le système de chauffage fait fondre du silicium polycristallin dans le creuset.

9. Appareil d'étirage de lingot selon l'une quelconque des revendications 2 à 3, comportant en outre une tige (168) couplée à la seconde soupape, dans lequel la tige actionne la seconde soupape.

10. Appareil d'étirage de lingot selon l'une quelconque des revendications 2 à 3, dans lequel le premier réservoir et le second réservoir sont maintenus à une pression supérieure à une pression de la chambre.

11. Procédé pour produire un lingot de silicium monocristallin à partir d'un bain de silicium fondu maintenu à l'intérieur d'un creuset (106) positionné à l'intérieur d'un appareil d'étirage de lingot (100), dans lequel l'appareil d'étirage de lingot comprend un injecteur de dopant (114) s'étendant dans une enceinte (102) de l'appareil d'étirage de lingot, l'injecteur de dopant comprenant un premier réservoir (156), une première soupape (162), un second réservoir (160), une seconde soupape (164), un tube d'injection de dopant (172) positionné à l'intérieur de l'enceinte et une coupelle de vaporisation (174) positionnée à l'intérieur du tube d'injection de dopant et de l'enceinte, le procédé comportant de :
ajouter du silicium polycristallin au creuset, le creuset étant disposé à l'intérieur d'une chambre intérieure d'étirage de lingot,
chauffer le silicium polycristallin pour entraîner la formation d'un bain de silicium fondu dans le creuset,
étirer un lingot de silicium monocristallin à partir du bain de silicium fondu,
injecter un dopant liquide dans l'appareil d'étirage de lingot :
en canalisant le dopant liquide du premier réservoir jusqu'au second réservoir en ouvre la première soupape, et
en canalisant le dopant liquide du second réservoir jusqu'à l'enceinte en ouvrant la seconde soupape,
vaporiser le dopant liquide en un dopant vaporisé à l'intérieur de l'appareil d'étirage de lingots :
en chauffant le dopant liquide en utilisant la coupelle de vaporisation, et
en réduisant une pression du dopant liquide en injectant le dopant liquide dans l'enceinte, dans lequel l'enceinte est maintenue à une pression inférieure à la pression atmosphérique, et
mettre en contact le dopant vaporisé avec une surface du bain fondu pour amener le dopant vaporisé dans le bain fondu comme un dopant tout en étirant le lingot de silicium monocristallin à partir du bain fondu.

12. Procédé pour doper un lingot de silicium monocristallin étiré à partir d'un bain de silicium fondu maintenu à l'intérieur d'un creuset (106) positionné à l'intérieur d'un appareil d'étirage de lingot (100), dans lequel l'appareil d'étirage de lingot comprend une enceinte (102), un injecteur de dopant (114) s'étendant dans l'enceinte, et un système de chauffage (176) positionné à l'intérieur de l'enceinte, l'injecteur de dopant comprenant un tube d'injection de dopant (172) positionné à l'intérieur de l'enceinte et une coupelle de vaporisation (174) positionnée à l'intérieur du tube d'injection de dopant et de l'enceinte, le procédé comportant de :
chauffer la coupelle de vaporisation en utilisant le système de chauffage, injecter du dopant liquide dans le tube d'injection de dopant et la coupelle de vaporisation,
vaporiser le dopant liquide en dopant vaporisé à l'intérieur de l'enceinte, dans lequel le dopant liquide est vaporisé par évaporation éclair en chauffant le dopant liquide avec la coupelle de vaporisation, et
canaliser le dopant vaporisé dans l'enceinte en utilisant le tube d'injection de dopant.

13. Procédé selon la revendication 12, dans lequel une pression d'un intérieur de l'enceinte est maintenue à une première pression, dans lequel une pression du dopant liquide est maintenue à une seconde pression supérieure à la première pression avant l'injection du dopant liquide dans le tube d'injection de dopant et la coupelle de vaporisation, et dans lequel le dopant liquide est vaporisé par évaporation éclair en chauffant le dopant liquide avec la coupelle de vaporisation et en réduisant la pression du dopant liquide de la seconde pression à la première pression en injectant le dopant liquide dans l'enceinte.

14. Procédé selon la revendication 12 ou la revendication 13, dans lequel le chauffage de la coupelle de vaporisation comporte le chauffage de la coupelle de vaporisation en utilisant de la chaleur rayonnante provenant du système de chauffage, dans lequel la chaleur rayonnante provenant du système de chauffage est la chaleur en excès provenant du système de chauffage lorsque le système de chauffage fait fondre du silicium polycristallin dans le creuset.

15. Procédé selon la revendication 11 ou la revendication 13, comportant en outre la canalisation d'un gaz inerte dans le tube d'injection de dopant, dans lequel le gaz inerte canalise le dopant vaporisé dans l'enceinte.

16. Procédé selon la revendication 13, dans lequel la première pression est une pression inférieure à la pression atmosphérique, ou dans lequel la première pression est un vide et la seconde pression est la pression atmosphérique.

17. Procédé selon la revendication 13, comportant en outre la diffusion du dopant vaporisé dans le bain de silicium fondu.

18. Procédé selon la revendication 12, dans lequel la coupelle de vaporisation comprend un récepteur (184) et un bouchon de vaporisation (186) positionné à l'intérieur du récepteur, et dans lequel le chauffage de la coupelle de vaporisation en utilisant le système de chauffage comporte le chauffage du bouchon de vaporisation positionné à l'intérieur du récepteur.

19. Procédé selon la revendication 11, dans lequel l'injecteur de dopant comprend un soufflet (138), dans lequel l'injection d'un dopant liquide dans l'appareil d'étirage de lingot comporte :
de déplacer le tube d'injection de dopant près du bain de silicium fondu en utilisant le soufflet, et
de diffuser le dopant vaporisé dans le bain de silicium fondu.

20. Procédé selon la revendication 11, comportant en outre le chauffage de la coupelle de vaporisation en utilisant de la chaleur rayonnante provenant d'un système de chauffage (176), dans lequel la chaleur rayonnante provenant du système de chauffage est la chaleur en excès provenant du système de chauffage lorsque le système de chauffage fait fondre du silicium polycristallin dans le creuset.

21. Procédé selon la revendication 11, dans lequel le premier réservoir et le second réservoir sont maintenus à une pression supérieure à la pression de l'enceinte, dans lequel la pression de l'enceinte est facultativement un vide et la pression du premier réservoir et du second réservoir est la pression atmosphérique.

22. Procédé selon la revendication 11, dans lequel la coupelle de vaporisation comprend un récepteur (184) et un bouchon de vaporisation (186) positionné à l'intérieur du récepteur, et dans lequel le chauffage du dopant liquide en utilisant la coupelle de vaporisation comporte de :
chauffer le bouchon de vaporisation positionné à l'intérieur du récepteur, et
chauffer le dopant liquide en utilisant le bouchon de vaporisation.

23. Procédé selon la revendication 12, dans lequel l'injecteur de dopant comprend un premier réservoir (156), une première soupape (162), un second réservoir (160) et une seconde soupape (164), dans lequel l'injection d'un dopant liquide dans l'appareil d'étirage de lingot comporte de :
canaliser le dopant liquide du premier réservoir jusqu'au second réservoir en ouvrant la première soupape ; et
canaliser le dopant liquide du second réservoir jusqu'à l'enceinte en ouvrant la seconde soupape.
